(19) Europäisches Patentamt

European Patent Office

Office européen des brevets

(11) EP 1 126 604 A2

(12) EUROPEAN PATENT APPLICATION

(43) Date of publication:
22.08.2001 Bulletin 2001/34

(51) Int Cl.⁷: H03H 9/54

(21) Application number: 01300516.0

(22) Date of filing: 22.01.2001

(84) Designated Contracting States:
AT BE CH CY DE DK ES FI FR GB GR IE IT LI LU
MC NL PT SE TR
Designated Extension States:
AL LT LV MK RO SI

(30) Priority: 04.02.2000 US 497859

(71) Applicant: LUCENT TECHNOLOGIES INC.
Murray Hill, New Jersey 07974-0636 (US)

(72) Inventor: Zierdt, Michael George
Belle Mead, New Jersey 08502 (US)

(74) Representative:
Buckley, Christopher Simon Thirsk et al
Lucent Technologies (UK) Ltd,
5 Mornington Road
Woodford Green, Essex IG8 0TU (GB)

(54) **Thin film resonator filter with inductance**

(57) A TFR filter (200) and method which utilizes inductance with at least one of a plurality of TFR components (210,220,230) of the filter. The TFR filter includes a plurality of TFR components (210, 220,230) typically arranged in an alternating series branch/shunt branch fashion. An inductor element (240,245,250) may be placed in series and/or parallel with at least one of the TFR components of the filter. The method provides the ability to increase pole-zero separation of the series branch and/or shunt branch TFR components while maintaining an acceptable return loss performance of the filter, so as to improve overall bandwidth.

FIG. 4

EP 1 126 604 A2

## Description

### Field Of The Invention

The present invention relates to thin film resonator (TFR) filters, more particularly to bandwidth widening for a TFR filter.

### Description Of The Related Art

Thin film resonators (hereinafter "TFR") are typically used in high-frequency environments ranging from several hundred megahertz (MHz) to several gigahertz (GHz). A TFR component typically comprises a piezoelectric material interposed between two conductive electrodes, one of which is formed on a support structure such as a membrane, or on a plurality of alternating reflecting layers formed on a semiconductor substrate which may be made of silicon or quartz, for example, or on another support structure. The piezoelectric material is preferably one selected from the group comprising at least ZnO, CdS and AlN. The electrodes are formed from a conductive material, preferably of Al, but may be formed from other conductors as well.

TFR components are often used in filters, more particularly in TFR filter circuits applicable to a myriad of communication technologies. For example, TFR filter circuits may be employed in cellular, wireless and fiber-optic communications, as well as in computer or computer-related information-exchange or information-sharing systems.

The desire to render these increasingly complicated communication systems portable and even hand-held place significant demands on filtering technology, particularly in the context of increasingly crowded radio frequency resources. TFR filters must meet strict performance requirements which include: (a) being extremely robust, (b) being readily mass-produced and (c) being able to sharply increase performance to size ratio achievable in a frequency range extending into the gigahertz region. However, in addition to meeting these requirements, there is a need for low passband insertion loss simultaneously coupled with demand for a relatively large stopband attenuation. Moreover, some of the typical applications noted above for these TFR filters require passband widths up to 4% of the center frequency (for example, for a 2 GHz center frequency, this would be a bandwidth of about 80 MHz). This is not easily achieved using common piezoelectrics such as AlN, especially on solidly mounted resonators.

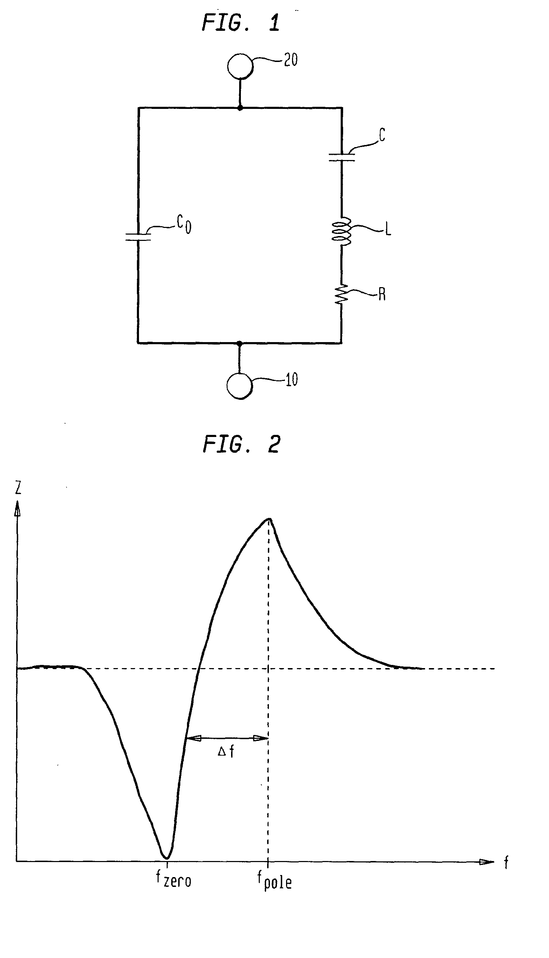

A conventional electrical circuit model for these TFR components is illustrated in Fig. 1. The circuit model is a Butterworth-Van Dyke model (BVD), and is comprised of a series RLC line which represents the motional (acoustic) resonance of the TFR between an input terminal 10 and output terminal 20, as shown in Fig. 1. The series RLC line is in parallel with a capacitor $C_o$ representing the parallel plate capacitance (static capacitance) of the electrodes of the TFR component.

Impedance analysis of the BVD model illustrated in Fig. 1 yields a set of two resonant frequencies, a zero resonant frequency ("zero") followed by a pole resonant frequency ("pole"). These zero and pole resonant frequencies of a TFR component are illustrated in Fig. 2. The resonant zero frequency "$f_{zero}$" is the frequency at which the series RLC of the circuit in Fig. 1 shorts out, where:

$$f_{zero} = \frac{1}{\sqrt{LC} \cdot 2\pi} \quad (1)$$

and the resonant pole frequency "$f_{pole}$" is the frequency at which the entire circuit acts as an open circuit, and is defined by:

$$f_{pole} = \frac{1}{\sqrt{LC_T} \cdot 2\pi} \quad (2) ,$$

where

$$C_T = 1/b, \text{ and } b = \frac{1}{C} + \frac{1}{Co}.$$

Thus, since $C_t < C$, $f_{pole}$ is slightly greater than $f_{zero}$. This is shown graphically as impedance (Z) versus frequency (f) in Fig. 2, where it can be seen that there is a slight spread between $f_{pole}$ and $f_{zero}$. This spread, or frequency distance ($\Delta f$) is, for example, about 40 MHz for a $f_{pole}$ = 2.0 GHz, or about 2% of the resonant pole frequency when using AlN as the piezoelectric in conjunction with reflecting layers on a solidly mounted substrate. The separation between zero and pole is dependent on a piezoelectric acoustic coupling coefficient known as $K^2$. This coefficient is a measure of how much of the acoustic energy is coupled into electrical, and varies with the piezoelectric material used in the TFR. Thus, $\Delta f$ is not a design parameter within the BVD model, but rather is dependent on the piezoelectric material of the TFR component (i.e., the size of $K^2$ is directly related to the amount of separation between pole and zero resonances).

A standard approach to designing filters out of resonators is to arrange them in a "T-Cell" configuration alternately in a series-shunt relationship (i.e., a "shunt" resonator connected in shunt at a terminal between two "series" resonators). Each of the shunt and series resonators has a pole resonance and a zero resonance. To achieve a bandpass filter response, it is common to shift the pole frequency of the shunt TFR component down in frequency to align with the zero frequency of the series TFR components. This shifting of shunt TFR component pole frequencies down in an attempt to match the series TFR components' pole frequencies is typically accomplished by adding some material (such as a metal, metal oxide, etc.) to the top electrode of the shunt TFR component.

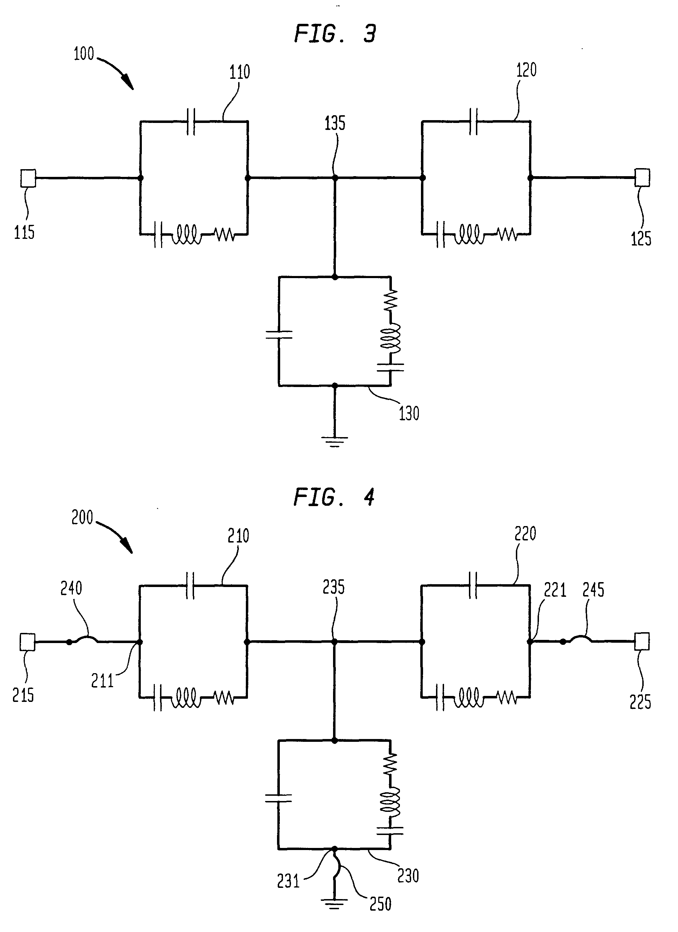

Currently, the conventional way of designing TFR ladder filters is to design simple building blocks of TFR components which are then concatenated together (connected or linked up in a series or chain). In a simplified view, concatenation helps to achieve a larger stopband attenuation for the filter because each individual linked up section in the chain successively filters the signal more as it passes through the chain. Fig. 3 illustrates this simple building block, commonly known as a T-Cell. Referring specifically to Fig. 3, a T-Cell building block 100 includes three TFR components 110, 120 and 130. TFR components 110 and 120 are each "series arm" portions of the T-Cell block, being connected in series between an input port 115 and node 135, and between node 135 and an output port 120 of T-Cell 100. TFR component 130 comprises the "shunt leg" portion of T-Cell 100, being connected in shunt between node 135 and ground. A TFR filter typically has a plurality of these T-cells concatenated together.

One problem with a TFR filter is that since the passband width is limited by the material parameter $K^2$, the filter suffers poor flexibility in widening the passband. The underlying problem is that the TFR component has a resonant pole frequency and a resonant zero frequency that lie close together, as shown previously in Fig. 2. Typically, in order to attempt widening the bandwidth for a TFR filter, the shunt TFR resonant frequency set (pole and zero) must be shifted further down. However, as the pole and zero resonant frequencies of the shunt TFR are shifted farther away from the series resonator frequencies, a "bump" quickly forms in the return loss response in the center of the band. This bump is an indicator that the TFR filter is becoming more "unmatched" to 50 ohms (the characteristic impedance of the filter), and illustrates the drop off in return loss match performance. More particularly, the bump in the return loss response in turn has an effect of limiting the amount of bandwidth achievable because eventually the "bump" will cause the filter to fail its return loss specification.

In the past, inductor compensation has been utilized with TFR filter circuits. Primarily, inductor compensation has been used in shunt with the TFR components as a method for manipulating the out-of-band (stopband) response. Specifically, inductor compensation was used for increasing rejection closer to the passband at the expense of further out rejection performance by effectively resonating out the parallel plate capacitance, $C_o$. However, inductor compensation has not heretofore been used in an effort to achieve wider bandwidth of a TFR filter over that currently obtainable.

Accordingly, there is a need for a TFR filter and method which can provide increased resonant pole-zero separation to improve overall bandwidths of the TFR filter. This would require a TFR filter and method which enables the pole-zero separation to be increased while still maintaining an acceptable return loss performance.

## Summary Of The Invention

The present invention utilizes inductance to provide a TFR filter which may have wider bandpass width as compared to that obtainable by a conventional TFR filter. The TFR filter circuit of the present invention includes a plurality of TFR components incorporated between an input port and output port of the filter, and an inductor element incorporated with at least one of the TFR components.

## Brief Description Of The Drawings

The present invention will become fully understood from the detailed description given hereinbelow and the accompanying drawings, wherein like elements represent like reference numerals, which are given by way of illustration only and thus are not limitative of the invention and wherein:

Fig. 1 illustrates a conventional electrical circuit model for a TFR component;

Fig. 2 illustrates an impedance versus frequency graph highlighting zero and pole resonant frequencies of a TFR component;

Fig. 3 illustrates a T-Cell used in a conventional TFR filter;

Fig. 4 illustrates the TFR filter circuit of the present invention using a series inductance arrangement;

Fig. 5 illustrates passband insertion loss performance for different series inductances with an appropriate shifting of resonant frequency sets;

Fig. 6 illustrates the passband return loss performance for different series inductances with an appropriate shifting of resonant frequency sets; and

Fig. 7 illustrates the TFR filter circuit of the present invention in a parallel inductance arrangement.

## Detailed Description

An embodiment of the present invention is directed to a thin film resonator (TFR) filter which may provide improved bandwidth performance by using inductance incorporated in TFR components of the filter. Incorporation as used herein includes inductance which can be integral with a TFR component on a substrate, coupled and/or connected to a TFR component either as a discrete element between the TFR component and another adjacent or adjoining device and/or system component, and/or arranged between a TFR component and a ground.

Use of inductance enables the zero resonant frequencies of the shunt and series TFR components to be effectively "pulled" further away from their respective resonant pole frequency (i.e., the zero shifts down in frequency for a series inductance case and the pole shifts up in frequency in a parallel inductance arrangement). Because pole-zero separation has increased, it is as if the effective $K^2$ of the material has increased. Since there is more separation between the pole and zero, the detrimental effects of one resonant frequency on the other is reduced, providing the opportunity to construct wider bandwidth filters for a given level of mismatch tolerance. This provides an overall widening in bandwidth as compared to what has been previously obtainable without the use of inductance.

Fig. 4 illustrates an example of a TFR filter circuit in accordance with the embodiment for the series inductance case. Although the TFR circuit 200 of Fig. 4 only depicts a single T-Cell (for convenience), the TFR filter 200 may be formed from a plurality of T-Cells concatenated together, as previously explained regarding Fig. 3, or by an arbitrary alternating number of interconnected series-shunt, shunt series, or any other arrangement of thin film resonator components.

Referring to Fig. 4, TFR filter 200 includes a pair of first TFR components 210 and 220 adjacently connected between an input port 215 and output port 225 of the TFR filter 200. First TFR components 210 and 220 are each series arm portions of the TFR filter 200. Ports 215 and 225 may in turn be connected to adjacent T-Cells or other system components, (not shown) depending on the desired application. Between first TFR components 210 and 220, a second TFR component 230 is connected in shunt to the series arm, between a node 235 and ground. Second TFR component 230 forms the shunt leg of the TFR filter 200.

In series with each of the TFR components 210, 220 and 230 are placed respective inductor components 240, 245 and 250. Specifically, inductor component 240 is arranged in series with series arm TFR component 210 between node 211 and input port 215; inductor component 245 is arranged in series with series arm TFR component 220 between node 221 and output port 225; and inductor component 250 is arranged in series with shunt leg TFR component 230 between node 231 and ground. Although Fig. 4 illustrates an inductor component placed in series with each TFR component of TFR filter 200, inductor components may alternatively be placed in series with at least one, several or all of the series arms of the filter, or solely in at least one, several or all of the shunt legs of the filter, and/or a combination of both depending on the degree of bandwidth widening that is desired or required for a particular application..

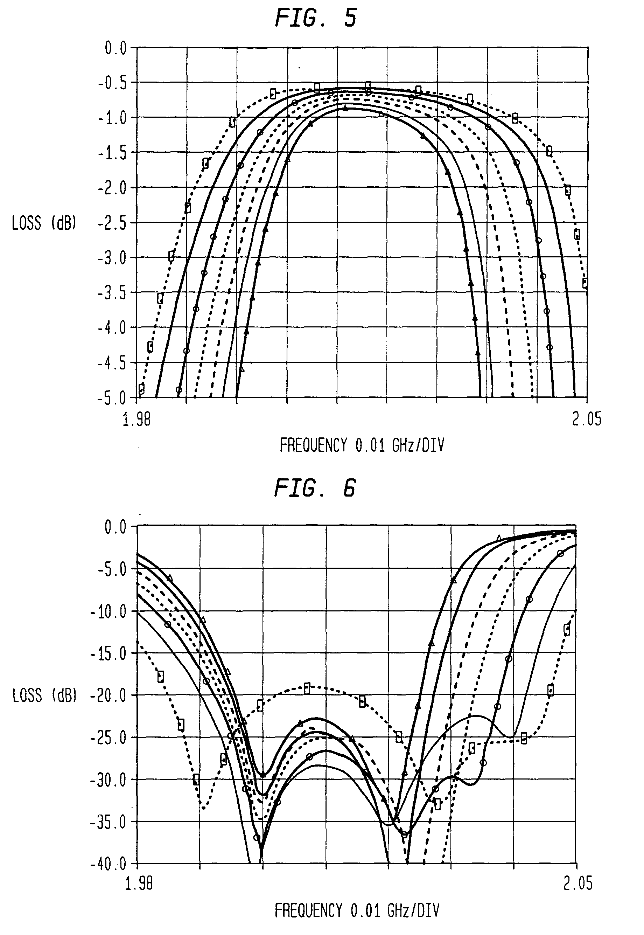

Fig. 5 illustrates passband insertion loss performance for different series inductances and appropriate resonator set down-shifting. Specifically, Fig. 5 is provided to illustrate the improved bandwidth obtainable by the series implementation of the present invention. Referring to Fig. 5, on a graph of insertion loss (y-axis in dB) versus frequency (x-axis: 1 block = 0.01 GHz/div or 10MHz/div), the individual response curves are plotted for different inductances in conjunction with increased down-shifting of the shunt TFR frequency sets with respect to the series TFR resonator frequency sets. Three of the response curves are annotated with comparison. The response curve annotated with a "Δ" represents the bandwidth for a TFR filter without using series inductance, and indicates a bandwidth of about 48 MHZ (counting 4.8 blocks at its widest point). The remaining five outer curves illustrate the bandwidth achievable using varying inductances and frequency set shifting in accordance with the present invention.

The amount of inductance used will depend on the amount of bandwidth widening desired, tempered by the need of maintaining an acceptable passband return loss performance, which is discussed below. Particularly, the more the resonant zero frequencies of the shunt and series TFR component are down-shifted away from their corresponding resonant pole frequencies, the greater the inductance required. The response curves annotated with a "O" and "□" represent other possible bandwidths achievable for the TFR filter in accordance with the present invention, indicating passband widths of approximately 75 MHz and over 90 MHz respectively.

Fig. 6 illustrates the passband return loss performance for different series inductances. Similar to Fig. 5, several of the response curves are labeled with Δ, O and □ symbols for comparison, and correspond to the passband insertion loss response curves outlined in Fig. 5. Referring to Fig. 6, it can be seen that the return loss performance varies little between a TFR filter using no series inductance (see Δ), and a TFR filter using varying amounts of inductance placed in series with the TFR resonators (see O and □) and the appropriate down shifting of the shunt TFR frequency sets.

Therefore, one embodiment of the present invention provides a TFR filter which uses inductors in series with at least one, some or all of the TFR components of the series arms and/or shunt legs of the TFR filter, in order to provide the ability to increase pole-zero separation, and therefore passband width, while maintaining an acceptable return loss performance- of the filter. Moreover, the present invention overcomes the material limitations of $K^2$ to some extent, to provide a TFR filter which can be used for typical cellular, wireless and fiber-optic communications, as well as in computer or computer-related information-exchange or information-sharing systems requiring passband widths up to about 4% of the center frequency (for example, an application requiring a filter with a 2 GHz center frequency, this would be a bandwidth of about 80 MHz). Further, using this configuration lowers the value of inductance, relative to the shunt configuration, and can allow for more flexible inductance implementations like wirebonds for instance, and requiring less space and inductor parasitics.

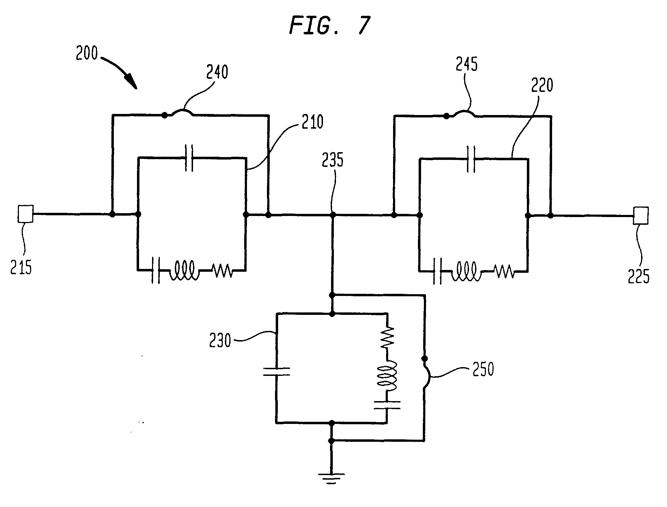

The invention being thus described, it will be obvious that the same may be varied in many ways. If higher inductance value implementation, size and accessibility of the bottom electrode are not much of a concern to the designer, then using inductors in parallel with TFR components may also be used to separate pole and zero resonant frequencies in a manner somewhat similar to that described above regarding series inductance arrangements. For example, Fig. 7 illustrates a TFR filter in accordance with the invention having a parallel inductance arrangement. Fig. 7 is the exact same circuit as Fig. 4, but illustrates inductor components coupled in parallel to TFR components instead of in series. Further, and unlike the series arrangement in Fig. 4, placed inductor elements in parallel with a TFR components shifts the resonant pole frequency of the TFR component up, instead of down-shifting the zero resonant frequency, to achieve the desirable bandwidth widening effect.

Referring to Fig. 7, in parallel with each of the TFR components 210, 220 and 230 are placed respective inductor components 240, 245 and 250. Specifically, inductor component 240 is arranged in parallel with series arm TFR component 210 between node 235 and input port 215; inductor component 245 is arranged in parallel with series arm TFR component 220 between node 235 and output port 225; and inductor component 250 is arranged in parallel with shunt leg TFR component 230 between node 235 and ground. Although Fig. 7 illustrates an inductor component placed in parallel with each TFR component of TFR filter 200, inductor components may alternatively be placed in parallel with at least one, several or all of the series arms of the filter, or in parallel with at least one, several or all of the shunt legs of the filter. Further, the filter may have combination of shunt legs and series arms in parallel with inductor components, depending on the degree of bandwidth widening required or desired by a particular application..

Accordingly, it may also be desirable to combine both series and parallel inductance arrangements in a single TFR filter to improve overall bandwidth of the filter. Such variations are not to be regarded as a departure from the spirit and scope of the invention, and also to modifications as would be obvious to one skilled in the art or intended to be included within the scope of the following claims.

**Claims**

1. A thin film resonator (TFR) filter, comprising:

    a plurality of TFR components coupled between an input port and an output port; and

    an inductor element incorporated in at least one of said plurality of TFR components in said filter.

2. The filter of claim 1, wherein an inductor element is placed in series with at least one of said plurality of TFR components.

3. The filter of claim 1, wherein said plurality of TFR components are in an alternating arrangement of series and shunt branches between said input and output ports.

4. The filter of claim 3, wherein an inductor element is placed in series with at least one of said TFR components in said shunt branch.

5. The filter of claim 3, wherein an inductor element is placed in series with at least one of said TFR components in said series branch.

6. The filter of claim 3, wherein a first inductor element is placed in series with at least one of said TFR components in said series branch; and wherein a second inductor element is placed in series with at least one of said TFR components in said shunt branch.

7. The filter of claim 1, wherein an inductor element is placed in parallel with at least one of said TFR components.

8. The filter of claim 3, wherein an inductor element is placed in parallel with at least one of said TFR components in said shunt branch.

9. The filter of claim 3, wherein an inductor element is placed in parallel with at least one of said TFR components in said series branch.

10. The filter of claim 3, wherein a first inductor element is placed in parallel with at least one of said TFR components in said series branch; and wherein a second inductor element is placed in parallel with at least one of said TFR components in said shunt branch.

11. The filter of claim 1, wherein said inductor element is at least a wirebond, a stub or a printed inductor.

12. A thin film resonator (TFR) filter, comprising:

    a plurality of TFR components coupled between an input port and an output port; and

    a first inductor element placed in series to at least one of said plurality of TFR components;

and

a second inductor element placed in parallel to at least one of said plurality of TFR components.

13. The filter of claim 12, wherein said plurality of TFR components are in an alternating arrangement of series and shunt branches between said input and output ports.

14. The filter of claim 13, wherein said first inductor element is placed in series with at least one of said TFR components in said series branch.

15. The filter of claim 13, wherein said first inductor element is placed in series with at least one of said TFR components in said shunt branch.

16. The filter of claim 13, wherein said first inductor element is placed in parallel with at least one of said TFR components in said series branch.

17. The filter of claim 13, wherein said first inductor element is placed in parallel with at least one of said TFR components in said shunt branch.

18. The filter of claim 12, wherein said first and second inductor elements are at least a wirebond, a stub or a printed inductor.

19. A method of widening bandwidth for a thin film resonator (TFR) filter, comprising:

providing a plurality of first TFR components between an input port and an output port; and

incorporating an inductor element into one of said TFR components.

20. The method of claim 19, wherein said coupling further includes placing an inductor element in series with at least one of said plurality of TFR components.

21. The method of claim 19, wherein said plurality of TFR components are coupled in an alternating arrangement of series and shunt branches.

22. The method of claim 21, wherein said coupling further includes placing an inductor element in series with at least one of said TFR components in said shunt branch.

23. The method of claim 21, wherein said coupling further includes placing an inductor element in series with at least one of said TFR components in said series branch.

24. The method of claim 21, wherein said coupling further includes placing a first inductor element in series with at least one of said TFR components in said series branch, and placing a second inductor element in series with at least one of said TFR components in said shunt branch.

25. The method of claim 19, wherein said coupling further includes placing an inductor element in parallel with at least one of said TFR components.

26. The method of claim 21, wherein said coupling further includes placing an inductor element in parallel with at least one of said TFR components in said shunt branch.

27. The method of claim 21, wherein said coupling further includes placing an inductor element in parallel with at least one of said TFR components in said series branch.

28. The method of claim 21, wherein said coupling further includes placing a first inductor element in parallel with at least one of said TFR components in said series branch, and placing a second inductor element in parallel with at least one of said TFR components in said shunt branch.

## FIG. 1

## FIG. 2

## FIG. 3

## FIG. 4

## FIG. 5

## FIG. 6

FIG. 7